(19) **Europäisches Patentamt**
**European Patent Office**
**Office européen des brevets**

(11) **EP 3 656 051 B1**

(12) **EUROPÄISCHE PATENTSCHRIFT**

(45) Veröffentlichungstag und Bekanntmachung des Hinweises auf die Patenterteilung:
**19.03.2025 Patentblatt 2025/12**

(21) Anmeldenummer: **18743782.7**

(22) Anmeldetag: **20.07.2018**

(51) Internationale Patentklassifikation (IPC):
*H02P 23/00* (2016.01)    *G05D 17/02* (2006.01)
*G01M 13/025* (2019.01)    *B60L 15/20* (2006.01)
*H02P 29/50* (2016.01)    *H02P 6/10* (2006.01)
*H02P 23/12* (2006.01)

(52) Gemeinsame Patentklassifikation (CPC):
**H02P 23/0022; B60L 15/20; G01M 13/025;**
**H02P 6/10; H02P 23/12; H02P 29/50;**
B60L 2220/14; B60L 2240/421; B60L 2240/423;
B60L 2260/44; B60L 2270/145; H02P 2101/45;
Y02T 10/64; Y02T 10/72

(86) Internationale Anmeldenummer:
**PCT/EP2018/069703**

(87) Internationale Veröffentlichungsnummer:
**WO 2019/016348 (24.01.2019 Gazette 2019/04)**

(54) **VERFAHREN UND VORRICHTUNG ZUM SCHÄTZEN DER DREHMOMENTWELLIGKEIT EINES ELEKTROMOTORS**

METHOD AND DEVICE FOR ESTIMATING THE TORQUE RIPPLE OF AN ELECTRIC MOTOR

PROCÉDÉ ET DISPOSITIF D'ESTIMATION DE L'ONDULATION DE COUPLE D'UN MOTEUR ÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **21.07.2017 AT 506132017**

(43) Veröffentlichungstag der Anmeldung:
**27.05.2020 Patentblatt 2020/22**

(73) Patentinhaber: **AVL List GmbH**
**8020 Graz (AT)**

(72) Erfinder:
• **KOKAL, Helmut**
**8020 Graz (AT)**

• **GIORDANO, Luigi**
**8075 Hart bei Graz (AT)**
• **PROPST, Mario**
**8742 Obdach (AT)**

(74) Vertreter: **Puchberger & Partner Patentanwälte**
**Reichsratsstraße 13**
**1010 Wien (AT)**

(56) Entgegenhaltungen:
**EP-A2- 2 447 120        EP-A2- 2 447 120**
**WO-A2-2009/034024    WO-A2-2009/034024**
**US-A- 5 534 764          US-A- 5 534 764**

**Beschreibung**

Die Erfindung betrifft ein Verfahren und eine Vorrichtung zum Schätzen der Drehmomentwelligkeit eines Elektromotors.

Elektromotoren, insbesondere Permanentmagnet-Synchronmotoren (PMSM), finden breite Anwendung im Automobilbereich. Diese Elektromotoren werden meistens im Verbund mit einem Getriebe und Antriebswellen zu den Antriebsrädern als Antriebsstrang eingesetzt. Solch ein Antriebsstrang stellt ein komplexes mechanisches System mit Struktur- und Torsions-Eigenmoden dar. Durch das Auftreten von periodischen Anregungen in Frequenzen in der Nähe der Frequenzen dieser Eigenmoden kann es für den Fahrer zu unangenehmen Geräuschen kommen. Aber auch Auswirkungen auf Bauteillebensdauer können die Folge sein, bis hin zur Zerstörung einzelner Antriebsstrangkomponenten.

Ein typischer Nebeneffekt bei der Verwendung derartiger Elektromotoren ist das Auftreten einer Drehmomentwelligkeit, die auch unter dem Begriff "Torque Ripple" oder "Ripple-Moment" bekannt ist. Darunter versteht man eine leicht drehwinkelabhängige Momentenverteilung über den Drehwinkel des Rotors des Elektromotors. Ursachen können eine ungleichmäßige Verteilung der Motorwicklung, Inhomogenitäten der Permanentmagnete, aber auch Asymmetrien der verwendeten Elektronikbauteile sein.

Typischerweise treten diese Drehmomentwelligkeiten in Ordnungen der Drehfrequenz auf, wobei die Ordnungszahl beispielsweise durch die Polpaarzahl und die Nutzahl bestimmt wird.

Ein weiterer typischer Nebeneffekt ist das Auftreten von sogenannten Rastmomenten bei solchen Motoren. Als Rastmoment bezeichnet man die Drehmomentwelligkeit des unbestromten Elektromotors.

Um die auftretende Drehmomentwelligkeit genau messen zu können, ist eine Messung des Drehmoments an der Abtriebswelle des Elektromotors von Vorteil. Üblicherweise ist jedoch im Elektromotor-Getriebe Verbund meist keine Drehmomentenmessung vorgesehen oder technisch schwierig zu realisieren.

Unter Anwendung eines Prüfstands, an dem das Abtriebsmoment des Elektromotors beispielsweise über einen Messflansch gemessen wird, kann die Drehmomentwelligkeit auch in einem Post-Processing Schritt berechnet werden. Dazu ist es jedoch erforderlich, die Drehzahl des Elektromotors zu messen und zu differenzieren. Dies ist während des Betriebs problematisch und meist nur durch Tiefpassfilterung des Mess-Signals möglich, was aufwändig und durchaus fehleranfällig ist.

Aus der US 5,534,764 A ist ein Verfahren zur Schätzung der Vibrationen des Antriebsstrangs bzw. der Antriebswelle eines Fahrzeugs im Betrieb unter Nutzung eines Fahrzeug-Systemmodells bekannt, welches jedoch nicht die Drehmomentwelligkeit des antreibenden Elektromotors berücksichtigt. Die WO 2009/034024 A2 beschreibt einen Prüfstand für einen elektrischen oder mechanischen Antrieb. Die EP 2 447 120 A2 beschreibt eine Fahrzeugsteuerung für ein Hybridkraftfahrzeug.

Eine Aufgabe der Erfindung besteht somit unter anderem darin, ein Verfahren sowie eine Vorrichtung bereitzustellen, durch die Drehmomentwelligkeiten eines Elektromotors am Prüfstand und im Betrieb möglichst genau geschätzt werden können.

Diese und andere Aufgaben werden erfindungsgemäß durch ein Verfahren gemäß Patentanspruch 1 gelöst. Das erfindungsgemäße Verfahren schätzt die Drehmomentwelligkeit $T_{TR}$ eines mit einer Last verbundenen Elektromotors aus einem Stellmoment $T_{set\_UUT}$ für den Elektromotor, einem an der Last gemessenen Abtriebsmoment $T_{shaft}$ und dem bekannten Massenträgheitsmoment J des Elektromotors, indem ein Regelkreis zur Nachführung der Drehzahl des Elektromotors gebildet wird. In der Regelstrecke des Regelkreises wird die Idealdrehzahl $\omega_{ideal}$ des Elektromotors bestimmt und durch den Regler des Regelkreises diese Idealdrehzahl $\omega_{ideal}$ der am Elektromotor gemessenen Realdrehzahl $\omega_{UUT}$ derart nachgeführt, dass die aktuelle Drehmomentwelligkeit $T_{TR}$ als Stellgröße am Ausgang des Reglers aufscheint. Die Stellgröße kann dann nach außen geführt und abgegriffen werden.

Der Regler kann insbesondere als PI-Regler ausgeführt sein. Das erfindungsgemäße Verfahren kann zum Schätzen der Drehmomentwelligkeit einer Permanentmagnet-Synchronmaschine eingesetzt werden. Das Verfahren kann vorteilhafterweise sowohl auf einem Prüfstand als auch direkt in einem Fahrzeug eingesetzt werden. Bei der Last kann es sich um eine steuerbare Last handeln. Das Verfahren kann auch während des Betriebs eines durch den Elektromotor angetriebenen Fahrzeugs eingesetzt werden, insoweit die Messgrößen Drehzahl und Wellenmoment bekannt sind. Dies ist vorteilhaft, da dadurch die Schätzung der Drehmomentwelligkeit in Echtzeit vorgenommen werden kann und kein komplexer Post-Processing Schritt notwendig ist. Des Weiteren ist keine Differenzierung der gemessenen Motordrehzahl notwendig.

Die Erfindung erstreckt sich auch auf eine Vorrichtung zum Schätzen der Drehmomentwelligkeit $T_{TR}$ eines, über eine Welle mit einer Last verbundenen Elektromotors. Die erfindungsgemäße Vorrichtung umfasst einen Sensor zur Messung der Realdrehzahl $\omega_{UUT}$ des Elektromotors und einen Sensor zur Messung des Abtriebsmoment $T_{shaft}$ der Last.

Die Vorrichtung umfasst weiters einen Regelkreis zur Nachführung der Drehzahl des Elektromotors mit einer Regelstrecke und einem Regler. In der Regelstrecke wird aus einem Stellmoment $T_{set\_UUT}$ des Elektromotors, dem Abtriebsmoment $T_{shaft}$ und einem Massenträgheitsmoment J des Elektromotors eine Idealdrehzahl $\omega_{ideal}$ des Elektromotors bestimmt. Der Regler ist derart ausgeführt, dass er die Idealdrehzahl $\omega_{ideal}$ der Realdrehzahl $\omega_{UUT}$ derart nachführt, dass die Drehmomentwelligkeit $T_{TR}$ als Stellgröße des Reglers erzeugt wird. Diese Stellgröße kann dann nach außen geführt und abgegriffen werden.

Erfindungsgemäß kann vorgesehen sein, dass die Vorrichtung Teil eines Prüfstands für einen Elektromotor ist. Erfindungsgemäß kann vorgesehen sein, dass der Elektromotor eine Permanentmagnet-Synchronmaschine, eine Asynchronmaschine oder ein Reluktanzmotor ist. Bei der Last kann es sich um eine steuerbare Last handeln. Die Vorrichtung kann aber auch Teil des Antriebs eines Fahrzeugs sein.

Weitere erfindungsgemäße Merkmale ergeben sich aus den Patentansprüchen, der Beschreibung der Ausführungsbeispiele und den Zeichnungen.

Die Erfindung wird im Folgenden an Hand eines exemplarischen Ausführungsbeispiels näher erläutert. Es zeigen

Fig. 1: einen herkömmlichen Aufbau eines Prüfstands für einen Elektromotor;
Fig 2a - 2c: Details einer Ausführungsform des erfindungsgemäßen Systems und Verfahrens.

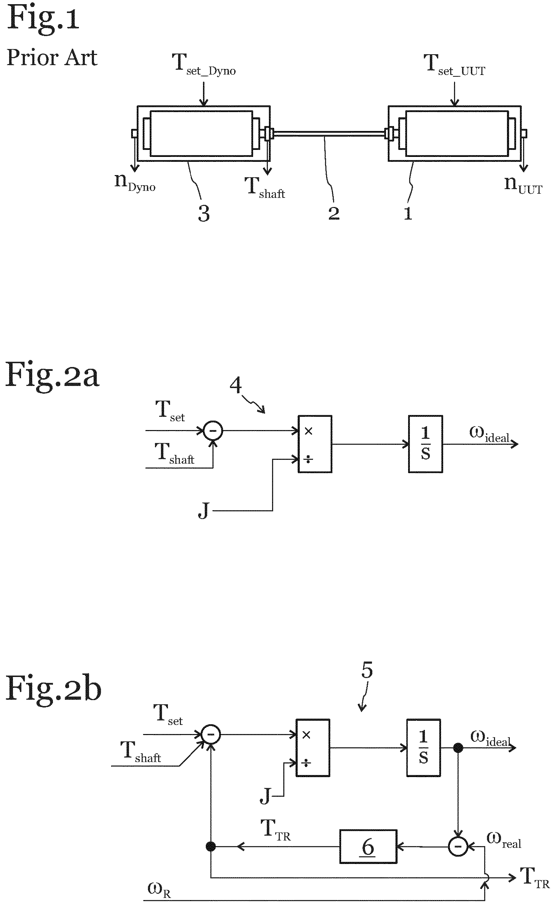

Fig. 1 zeigt einen herkömmlichen Aufbau eines Prüfstands für einen Elektromotor 1. Der zu prüfende Elektromotor 1 (Prüfling bzw. Unit-Under-Test UUT) ist über eine Welle 2 mit einer steuerbaren Last 3 verbunden. Mit einer (in dieser Figur nicht dargestellten) Regeleinheit 4 der Last 3 werden unterschiedliche Belastungszustände für den zu prüfenden Elektromotor 1 vorgegeben, beispielsweise eine Vorgabe der zu erreichenden Drehzahl oder des zu erreichenden Drehmoments. Derartige Prüfstände werden in der Regel ohne Getriebe, Antriebsstrang und weitere Antriebskomponenten verwendet.

In dieser Figur bezeichnen $T_{set\_UUT}$ das Stellmoment und $n_{UUT}$ die gemessene Drehzahl am zu prüfenden Elektromotor 1. Das Symbol $T_{shaft}$ bezeichnet das an der Welle 2 gemessene Abtriebsmoment. Das an der Last 3 vorgegebene Drehmoment ist mit dem Symbol $T_{set\_Dyno}$ bezeichnet, und die an der Last 3 gemessene Drehzahl mit dem Symbol $n_{Dyno}$.

Aus der am Prüfling gemessenen Drehzahl kann eine Berechnung der Drehmomentwelligkeit (Ripple-Moment) $T_{TR}$ in einem Post-Processing Schritt erfolgen, wobei dazu das vorab bestimmte Massenträgheitsmoment $J_{UUT}$ des Elektromotors 1 herangezogen wird:

$$T_{TR} = J_{UUT}\left(\dot{n}_{UUT}\frac{\pi}{30}\right) - T_{set_{UUT}} + T_{shaft}$$

Eine Differenzierung der gemessenen Drehzahl $n_{UUT}$ im laufenden Betrieb ist jedoch problematisch und meist nur mit Tiefpassfilterung des Signals sinnvoll möglich.

Fig.2a zeigt einen idealen Drehmomenterzeuger 4, der als Teil des erfindungsgemäßen Verfahrens eingesetzt werden kann. In diesem idealen Drehmomenterzeuger 4 bezeichnet $T_{set}$ das Stellmoment, $T_{shaft}$ das gemessene Abtriebsmoment, und $\omega_{ideal}$ die Drehzahl des idealen Elektromotors. Mit dem Symbol J wird das Massenträgheitsmoment des Elektromotors bezeichnet. Der mathematische Zusammenhang lautet:

$$\omega_{ideal} = \frac{1}{J}\int\left(T_{set} - T_{shaft}\right)$$

Für die Berechnung der realen Drehzahl $\omega_{real}$ addiert sich zum Stellmoment und Abtriebsmoment die unbekannte Drehmomentwelligkeit (Ripple-Moment) $T_{TR}$:

$$\omega_{real} = \frac{1}{J}\int\left(T_{set} - T_{shaft} + T_{TR}\right)$$

Somit wird die ideale Drehzahl $\omega_{ideal}$ gleich der realen Drehzahl $\omega_{real}$ wenn am Eingang des idealen Elektromotors das Ripple-Moment $T_{TR}$ zusätzlich zum Stellmoment und dem Abtriebsmoment berücksichtigt wird.

Fig. 2b zeigt einen entsprechend ausgeführten Regelkreis 5, bei dem die ideale Drehzahl $\omega_{ideal}$ als Regelgröße der realen gemessenen Drehzahl $\omega_{real}$ als Führungsgröße nachgeführt wird. Zu diesem Zweck ist ein Regler 6 vorgesehen, der im vorliegenden Ausführungsbeispiel als PI-Regler ausgeführt ist. Dem Regler 6 wird die Differenz zwischen idealer Drehzahl $\omega_{ideal}$ und realer Drehzahl $\omega_{real}$ als Regelabweichung zugeführt.

Der Regler 6 liefert als Stellgröße eine Drehmomentabweichung. Der Stellgröße wird in der Regelstrecke das aktuelle Stellmoment $T_{set}$ und das gemessene Abtriebsmoment $T_{shaft}$ abgezogen, und das Ergebnis durch das Massenträgheitsmoment J dividiert sowie die Integration nach der Zeit gebildet, sodass die aktuelle Drehzahl als Regelgröße gebildet wird.

Die Ausgangsgröße des Reglers 6 entspricht somit der aktuellen Drehmomentwelligkeit, also dem Ripple-Moment $T_{TR}$. Die jeweils aktuelle Drehmomentwelligkeit ergibt sich in diesem Regelkreis 5 somit automatisch als Nebenprodukt der geführten Drehzahlregelung.

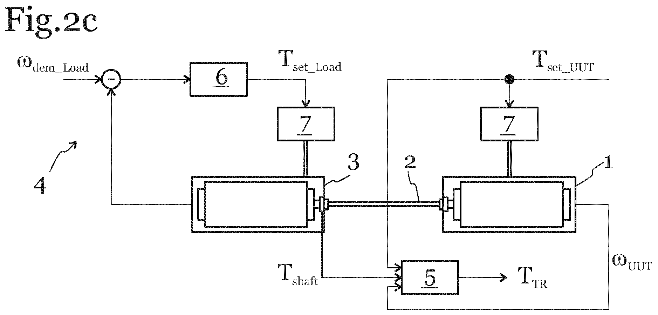

Fig. 2c zeigt eine Ausführungsform der Erfindung am Beispiel eines konkreten Prüfstands. Wiederum ist der zu prüfende Elektromotor 1 über eine Welle 2 mit einer steuerbaren Last 3 verbunden. In dieser Figur bezeichnet $T_{set\_UUT}$ wieder das Stellmoment des zu prüfenden Elektromotors 1 und $\omega_{UUT}$ die gemessene Drehzahl am zu prüfenden Elektromotor 1.

Der Regler 6' berechnet aus der Differenz der Drehzahl der Last 3 und der vorgegebenen Drehzahl $\omega_{dem\_Load}$ das Soll-Drehmoment $T_{set\_Load}$ der Last 3. Sowohl die Last 3, als auch der zu prüfende Elektromotor 1 werden über eine Treibereinheit 7 angesteuert, welche das gewünschte Drehmoment $T_{set\_Load}$ und $T_{set\_UUT}$ in entsprechende Ansteuersignale für die Last 3 bzw. den Elektromotor 1 umsetzt. Das Symbol $T_{shaft}$ bezeichnet wieder das an der Welle 2 gemessene Abtriebsmoment.

Aus $T_{set\_UUT}$, $T_{shaft}$ und der gemessenen Drehzahl $\omega_{UUT}$ wird, wie im Zusammenhang mit Fig. 2b erläutert, im Regelkreis 5 das aktuelle Ripple-Moment $T_{TR}$ bestimmt, ohne dass eine Differenzierung der aktuellen Drehzahl des Elektromotors erforderlich ist.

Die Erfindung beschränkt sich nicht auf eine konkrete Ausführung des Elektromotors, der Last, oder des Regelkreises, sondern umfasst sämtliche Verfahren und Vorrichtungen im Rahmen der nachfolgenden Patentansprüche.

**Patentansprüche**

1. Verfahren zum Schätzen der Drehmomentwelligkeit $T_{TR}$ eines mit einer Last (3) verbundenen Elektromotors (1), wobei aus einem Stellmoment $T_{set\_UUT}$ für den Elektromotor (1), einem an der Last (3) gemessenen Abtriebsmoment $T_{shaft}$ und einem Massenträgheitsmoment J des Elektromotors (1) in der Regelstrecke eines Regelkreises (5) die Idealdrehzahl $\omega_{ideal}$ des Elektromotors (1) bestimmt wird, wobei durch den Regler (6) des Regelkreises (5) die Idealdrehzahl $\omega_{ideal}$ der am Elektromotor (1) gemessenen Realdrehzahl $\omega_{UUT}$ derart nachgeführt wird, dass die aktuelle Drehmomentwelligkeit $T_{TR}$ als Stellgröße des Reglers (6) erzeugt wird, wobei die aktuelle Drehmomentwelligkeit $T_{TR}$ nach außen geführt und abgegriffen wird, **dadurch gekennzeichnet, dass**

   - das Verfahren auf einem Prüfstand für den Elektromotor (1) eingesetzt wird, und
   - die Idealdrehzahl $\omega_{ideal}$ des Elektromotors (1) bestimmt wird, indem dem Stellmoment $T_{set\_UUT}$ das aktuelle Stellmoment $T_{set}$ und das gemessene Abtriebsmoment $T_{shaft}$ abgezogen und das Ergebnis durch das Massenträgheitsmoment J dividiert sowie die Integration nach der Zeit gebildet wird.

2. Verfahren nach Anspruch 1, **dadurch gekennzeichnet, dass** das Verfahren zum Schätzen der Drehmomentwelligkeit einer Permanentmagnet-Synchronmaschine eingesetzt wird.

3. Verfahren nach Anspruch 1 oder 2, **dadurch gekennzeichnet, dass** es sich bei der Last (3) um eine steuerbare Last (3) handelt.

4. Verfahren nach einem der Ansprüche 1 bis 3, **dadurch gekennzeichnet, dass** das Verfahren zur Drehmomentenwelligkeitskompensation eingesetzt wird.

5. Vorrichtung zum Schätzen der Drehmomentwelligkeit $T_{TR}$ eines mit einer Last (3) verbundenen Elektromotors (1), umfassend einen Sensor zur Messung der Realdrehzahl $\omega_{UUT}$ des Elektromotors (1) und einen Sensor zur Messung des Abtriebsmoment $T_{shaft}$ der Last (3),

   wobei die Vorrichtung einen Regelkreis (5) umfasst, wobei der Regelkreis (5)

   a. eine Regelstrecke umfasst, in der aus einem Stellmoment $T_{set\_UUT}$ des Elektromotors (1), dem Abtriebsmoment $T_{shaft}$ und einem Massenträgheitsmoment J des Elektromotors (1) eine Idealdrehzahl $\omega_{ideal}$ des Elektromotors (1) bestimmt wird, b. und einen Regler (6) umfasst, der die Idealdrehzahl $\omega_{ideal}$ der Realdrehzahl $\omega_{UUT}$ derart nachführt, dass die Drehmomentwelligkeit $T_{TR}$ als Stellgröße des Reglers (6) erzeugt wird,

   wobei die aktuelle Drehmomentwelligkeit $T_{TR}$ nach außen geführt und abgegriffen wird, **dadurch gekennzeichnet, dass**

   - die Vorrichtung Teil eines Prüfstands für den Elektromotor (1) ist, und
   - der Regelkreis (5) dazu ausgebildet ist, die Idealdrehzahl $\omega_{ideal}$ des Elektromotors zu bestimmen, indem dem Stellmoment $T_{set\_UUT}$ das aktuelle Stellmoment $T_{set}$ und das gemessene Abtriebsmoment $T_{shaft}$ abgezogen und das Ergebnis durch das Massenträgheitsmoment J dividiert sowie die Integration nach der Zeit gebildet wird.

6. Vorrichtung nach Anspruch 5, **dadurch gekennzeichnet, dass** es sich bei der Last (3) um eine steuerbare Last (3) handelt.

7. Vorrichtung nach Anspruch 5 oder 6, **dadurch gekennzeichnet, dass** der Elektromotor (1) eine Permanentmagnet-Synchronmaschine ist.

**Claims**

1. A method for estimating the torque ripple $T_{TR}$ of an electric motor (1) connected to a load (3), wherein the ideal rotational speed $\omega_{ideal}$ of the electric motor (1) is determined from an actuating torque $T_{set\_UUT}$ for the electric motor (1), an output torque $T_{shaft}$ measured at the load (3) and a mass moment of inertia J of the electric motor (1) in the control path of a control loop (5), wherein the ideal rotational speed $\omega_{ideal}$ is lead to follow the real rotational speed $\omega_{UUT}$ measured on the electric motor (1) by means of the controller (6) of the control loop (5) in such a way that the current torque ripple $T_{TR}$ is generated as a control variable of the controller (6), wherein the current torque ripple $T_{TR}$ is fed to the outside and tapped, **characterised in that**

- the method is used on a test stand for the electric motor (1), and
- the ideal rotational speed $\omega_{ideal}$ of the electric motor (1) is determined by subtracting the current control torque $T_{set}$ and the measured output torque $T_{shaft}$ from the control torque $T_{set\_UUT}$ and dividing the result by the mass moment of inertia J and integrating over time.

2. The method according to claim 1, **characterised in that** the method is used to estimate the torque ripple of a permanent magnet synchronous machine.

3. The method according to claim 1 or 2, **characterised in that** the load (3) is a controllable load (3).

4. The method according to any one of claims 1 to 3, **characterised in that** the method is used for torque ripple compensation.

5. A device for estimating the torque ripple $T_{TR}$ of an electric motor (1) connected to a load (3), comprising a sensor for measuring the real rotational speed $\omega_{UUT}$ of the electric motor (1) and a sensor for measuring the output torque $T_{shaft}$ of the load (3),

wherein the device comprises a control loop (5), wherein the control loop (5)

a. comprises a control path in which an ideal rotational speed $\omega_{ideal}$ of the electric motor (1) is determined from an actuating torque $T_{set\_UUT}$ of the electric motor (1), the output torque $T_{shaft}$ and a mass moment of inertia J of the electric motor (1),
b. and comprises a controller (6) which leads the ideal rotational speed $\omega_{ideal}$ to follow the real rotational speed $\omega_{UUT}$ in such a way that the torque ripple $T_{TR}$ is generated as a control variable of the controller (6),

wherein the current torque ripple $T_{TR}$ is fed to the outside and tapped, **characterised in that**

- the device is part of a test stand for the electric motor (1), and
- the control loop (5) is designed to determine the ideal rotational speed $\omega_{ideal}$ of the electric motor by subtracting the current control torque $T_{set}$ and the measured output torque $T_{shaft}$ from the control torque $T_{set\_UUT}$ and dividing the result by the mass moment of inertia J and integrating over time.

6. The device according to claim 5, **characterised in that** the load (3) is a controllable load (3).

7. The device according to claim 5 or 6, **characterised in that** the electric motor (1) is a permanent magnet synchronous machine.

**Revendications**

1. Procédé d'estimation de l'ondulation de couple $T_{TR}$ d'un moteur électrique (1) relié à une charge (3), dans lequel la vitesse de rotation idéale $\omega_{ideal}$ du moteur électrique (1) est déterminée à partir d'un couple de commande $T_{set\_UUT}$ pour le moteur électrique (1), d'un couple de sortie $T_{shaft}$ mesuré sur la charge (3) et d'un moment d'inertie de masse J du moteur électrique (1) dans le système contrôlé d'un circuit de régulation (5), dans lequel la vitesse de rotation idéale $\omega_{ideal}$ est asservie par le régulateur (6) du circuit de régulation (5) à la vitesse de rotation réelle $\omega_{UUT}$ mesurée sur le moteur électrique (1) de telle sorte que l'ondulation de couple actuelle $T_{TR}$ soit générée comme grandeur de commande du régulateur (6), dans lequel l'ondulation de couple actuelle $T_{TR}$ est guidée vers l'extérieur et prélevée, **caractérisé**

- **en ce que** le procédé est utilisé sur un banc d'essai pour le moteur électrique (1), et
- **en ce que** la vitesse de rotation idéale $\omega_{ideal}$ du moteur électrique (1) est déterminée en soustrayant du couple de commande $T_{set\_UUT}$ le couple de commande actuel $T_{set}$ et le couple de sortie mesuré $T_{shaft}$, et en divisant le résultat par le moment d'inertie de masse J et en formant l'intégration en fonction du temps.

2. Procédé selon la revendication 1, **caractérisé en ce que** le procédé est utilisé pour estimer l'ondulation de couple d'une machine synchrone à aimants permanents.

3. Procédé selon la revendication 1 ou 2, **caractérisé en ce que** la charge (3) est une charge (3) contrôlable.

4. Procédé selon l'une des revendications 1 à 3, **caractérisé en ce que** le procédé est utilisé pour la compensation de l'ondulation de couple.

5. Dispositif d'estimation de l'ondulation de couple $T_{TR}$ d'un moteur électrique (1) relié à une charge (3), comprenant un capteur de mesure de la vitesse de rotation réelle $\omega_{UUT}$ du moteur électrique (1) et un capteur de mesure du couple de sortie $T_{shaft}$ de la charge (3), dans lequel le dispositif comprend un circuit de régulation (5), dans lequel le circuit de régulation (5) comprend

a. un système contrôlé dans lequel une vitesse de rotation idéale $\omega_{ideal}$ du moteur électrique (1) est déterminée à partir d'un couple de commande $T_{set\_UUT}$ du moteur électrique (1), du couple de sortie $T_{shaft}$ et d'un couple d'inertie de masse J du moteur électrique (1),

b. et un régulateur (6) qui asservit la vitesse de rotation idéale $\omega_{ideal}$ à la vitesse de rotation réelle $\omega_{UUT}$ de telle sorte que l'ondulation de couple $T_{TR}$ est générée comme grandeur de commande du régulateur (6),

dans lequel l'ondulation de couple actuelle $T_{TR}$ est guidée vers l'extérieur et prélevée, **caractérisé**

- **en ce que** le dispositif fait partie d'un banc d'essai pour le moteur électrique (1), et
- **en ce que** le circuit de régulation (5) est conçu pour déterminer la vitesse de rotation idéale $\omega_{idéale}$ du moteur électrique en soustrayant du couple de commande $T_{set\_UUT}$ le couple de commande actuel $T_{set}$ et le couple de sortie mesuré $T_{shaft}$, et en divisant le résultat par le moment d'inertie de masse J et en formant l'intégration en fonction du temps.

6. Dispositif selon la revendication 5, **caractérisé en ce que** la charge (3) est une charge contrôlable (3).

7. Dispositif selon la revendication 5 ou 6, **caractérisé en ce que** le moteur électrique (1) est une machine synchrone à aimants permanents.

# Fig.1
## Prior Art

# Fig.2a

# Fig.2b

Fig.2c

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5534764 A
- WO 2009034024 A2
- EP 2447120 A2